(19) **Europäisches Patentamt / European Patent Office / Office européen des brevets**

(11) **EP 1 353 369 B1**

(12) **EUROPEAN PATENT SPECIFICATION**

(45) Date of publication and mention
of the grant of the patent:
**12.12.2007 Bulletin 2007/50**

(51) Int Cl.:
***H01L 21/762*** *(2006.01)*

(21) Application number: **03251430.9**

(22) Date of filing: **10.03.2003**

(54) **Method for producing semiconductor device**

Verfahren zur Herstellung eines Halbleiterbauelements

Procédé de fabrication d'un dispositif semi-conducteur

(84) Designated Contracting States:
**DE FR GB**

(30) Priority: **29.03.2002 US 112014**

(43) Date of publication of application:
**15.10.2003 Bulletin 2003/42**

(73) Proprietor: **Sharp Kabushiki Kaisha**
**Osaka 545-8522 (JP)**

(72) Inventors:
 • **Evans, David Russell**
 **Beaverton, OR 97007 (US)**
 • **Hsu, Sheng Teng**
 **Camas, WA 98607 (US)**
 • **Ulrich, Bruce Dale**
 **Beaverton, OR 97008 (US)**
 • **Tweet, Douglas James**
 **Camas, WA 98607 (US)**
 • **Stecker, Lisa H.**
 **Vancouver, WA 98683 (US)**

(74) Representative: **Brown, Kenneth Richard et al**
**R.G.C. Jenkins & Co.**
**26 Caxton Street**
**London SW1H 0RJ (GB)**

(56) References cited:
| | |
|---|---|
| **EP-A- 0 744 766** | **EP-A- 0 875 927** |
| **WO-A-99/46081** | **US-A- 5 202 277** |
| **US-A- 5 238 859** | **US-A- 5 362 668** |
| **US-A- 5 665 202** | **US-A- 5 733 801** |
| **US-A- 5 948 698** | **US-A- 6 091 129** |
| **US-A- 6 133 115** | **US-A1- 2001 039 099** |
| **US-A1- 2002 037 626** | **US-B1- 6 218 262** |

• **KATO M ET AL: "A shallow-trench-isolation flash memory technology with a source-bias programming method" ELECTRON DEVICES MEETING, 1996., INTERNATIONAL SAN FRANCISCO, CA, USA 8-11 DEC. 1996, NEW YORK, NY, USA, IEEE, US, 8 December 1996 (1996-12-08), pages 177-180, XP010207562 ISBN: 0-7803-3393-4**
• **PATENT ABSTRACTS OF JAPAN vol. 015, no. 233 (E-1077), 14 June 1991 (1991-06-14) -& JP 03 070180 A (FUJITSU LTD), 26 March 1991 (1991-03-26)**

**Description**

BACKGROUND OF THE INVENTION

1. FIELD OF THE INVENTION:

The present invention relates to a method for producing a semiconductor device, such as semiconductor integrated circuit, using an element isolation process for isolating device elements by insulators, and more particularly to a method for producing a semiconductor device using a self-aligned shallow trench isolation (self-aligned STI) process for isolating, for example, device elements formed in a self-aligned gate structure.

2. DESCRIPTION OF THE RELATED ART:

Conventionally, several element isolation methods for isolating adjacent device structures, for example, transistors, on a semiconductor substrate have been used. One element isolation method using a semiconductor process that has been used since the 1970s is local oxidation of silicon (hereinafter, referred to as "LOCOS"), which is commonly referred to as selective oxidation. LOCOS is a locally selective oxidation isolation process.

Another element isolation method is direct shallow trench isolation, also known as direct STI. This is a simple shallow trench element isolation process. Trenches are etched in a silicon substrate through a mask layer, e.g., an oxide mask or a nitride mask. The resulting trench is then refilled with silicon dioxide and planarized using a chemical mechanical polishing (CMP) process.

A modified STI process has also been used. Gate oxide is grown and a first polysilicon layer is deposited after well formation. Silicon trenches are etched through the gate oxide and the first polysilicon layer. The trenches are then refilled with oxide followed by a second polysilicon layer. The first polysilicon and the second polysilicon layer are both used to form at least a portion of the polysilicon gate electrode.

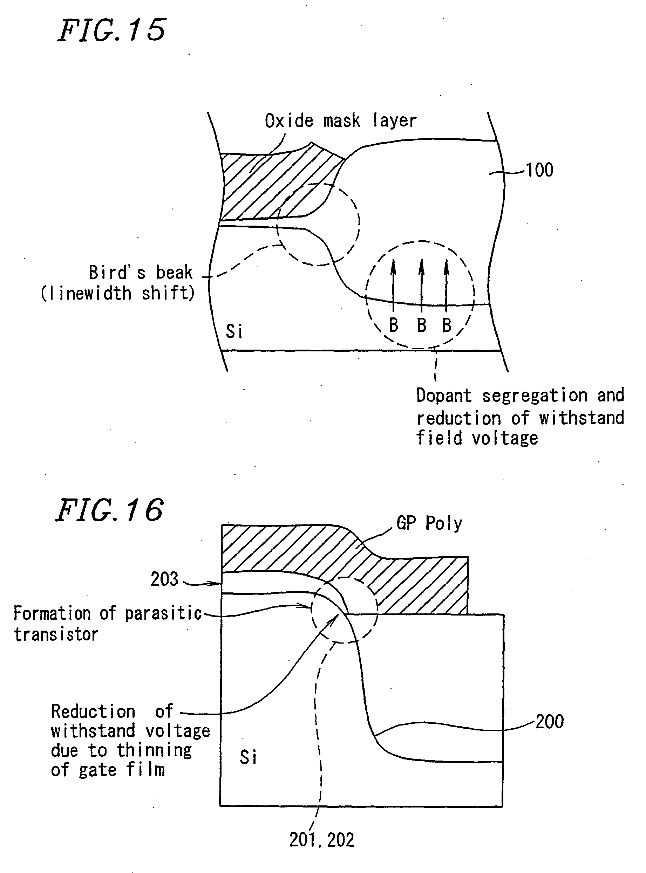

One of the limitations of the conventional LOCOS isolation process is due to lateral oxidation under a nitride mask layer used to define the isolation region, causing a field oxide 100, which isolates elements, to have a characteristic "bird's beak" shape as shown in Figure 15. The bird's beak reduces the effective channel width of a transistor device between isolated elements and causes threshold voltage non-uniformity within the transistors to be formed.

The LOCOS isolation process also has limitations known to those of ordinary skill in the art, e.g., defect generation, segregation of doping in the field region. For example, defects can be generated around the perimeter of the device. The segregation of boron (B) into the field oxide 100 causes a reduction of field threshold voltage and increased field leakage current. In the worst case, adjacent devices can become electrically connected through the field region.

A disadvantage of the direct STI process is that, as shown in Fig. 16, corners 201 of the trenches 200 between device elements must be rounded to prevent the formation of a parasitic edge transistor, breakdown of the gate oxide layer 203 at the edge 202 of the active regions, or both. Consequently, this isolation process also causes channel width reduction and threshold voltage non-uniformity.

The main drawback of the modified STI process is post-polish thickness control of the first polysilicon layer, which causes difficulty with end point detection of the gate polysilicon etch. The various STI processes provide a flat surface, which makes lithographic patterning easier. However, there are no inherent alignment marks, so additional photoresist mask steps must be used to etch an alignment key.

US 5 362 668 discloses a method of fabricating a semi-conductor device by forming, on a P-type silicon substrate, a memory cell portion partitioned with a field oxide film, forming trenches in self-alignment with a polycrystalline silicon film which act as gate electrodes in the semiconductor device, completely burying second and third oxide films in the trenches, removing the third oxide film near the end of the field oxide film by using a second resist film as a mask and thereafter etching-back the whole surface to cause the second and third oxide films to remain only in the trenches. According to the method, the oxide film can be stably buried in the trenches.

US 5 948 698 discloses a method for fabricating a semiconductor device at low cost in which a mask layer having a very large polishing selection ratio is used as a polishing stop film by forming the polishing stop film in self-alignment. An object layer to be flattened is formed on a substrate. The object layer contains an irregularity. A polishing stop film which is polished at a slower rate and a mask layer which is polished at about the same rate as the object layer are deposited on the object layer. Then the mask layer on a high level portion of the object layer is removed by chemicalmechanical polishing. The polishing stop film is etched other than under the mask layer, so that the polishing stop film at the high level portion and side wall of the step is removed. After that, the mask layer and the object layer at the convex portion are removed by CMP to level of the object layer with the concave portion.

## SUMMARY OF THE INVENTION

According to the present invention, there is provided a method for producing a semiconductor device using a self-aligned shallow trench isolation process which isolates elements formed so as to be self-aligned to a gate structure, the method comprising the steps of: providing a first polysilicon layer overlying a gate insulator layer on a substrate; forming a trench through the first polysilicon layer, and into the substrate; providing an oxide layer overlying the substrate including the trench such that a top surface of the oxide layer within the trench is higher than a bottom surface of the first polysilicon layer; providing a second polysilicon layer overlying the oxide layer such that a top surface of the second polysilicon layer within the trench is lower than the top surface of the first polysilicon layer; and planarizing the second polysilicon layer, the oxide layer, and the first polysilicon layer, while stopping the step of planarizing at the top surface of the second polysilicon layer within the trench, selectively etching the second polysilicon layer and the first polysilicon layer to pattern the gate structure using a mask, while detecting an etch stop at the completion of removal of the second polysilicon layer to selectively etch a remainder of the first polysilicon layer using an etch with high selectivity to the underlying gate insulator layer, whereby the gate structure is formed.

In one embodiment of the invention, the oxide layer is formed by growing a thin thermal oxide and then depositing the remainder of the oxide using a CVD process, or sputtering.

In another embodiment of the invention, the gate insulator layer is silicon dioxide.

In still another embodiment of the invention, the gate insulator layer comprises at least one of silicon oxide, silicon oxynitride, hafnium oxide, zirconium oxide and lanthanum oxide.

In still another embodiment of the invention, the method for producing a semiconductor device further comprises the step of etching the oxide layer using an oxide selective etch after the step of planarizing, whereby an alignment key is formed in the oxide layer.

Preferably, the method for producing a semiconductor device comprising the steps of: providing a third polysilicon layer on a substrate after planarizing; and selectively etching the third polysilicon layer, a second polysilicon layer, and a first polysilicon layer using patterned photoresist during formation of a gate structure, while detecting an etch stop at the completion of removal of the second polysilicon layer, whereby a thin layer of first polysilicon layer remains.

Preferably, the method for producing a semiconductor device further comprises the steps of: selectively etching the oxide following the step of planarizing the second polysilicon layer, whereby an alignment key is formed in the oxide layer.

In one embodiment of the invention, the oxide within the trench is etched to remove approximately 100 nanometers of oxide.

Preferably, the method for producing a semiconductor device further comprises the steps of: prior to performing the planarizing step, providing a sacrificial oxide layer over the second polysilicon layer; wherein the planarization step includes planarizing the sacrificial oxide layer selectively etching the oxide layer using an oxide selective etch, whereby an alignment key is formed in the oxide layer; providing a third polysilicon layer overlying the substrate; providing photoresist over the third polysilicon layer and patterning the photoresist to define a gate structure; and selectively etching the third polysilicon layer, the second polysilicon layer, and the first polysilicon layer using the photoresist, while detecting an etch stop at the completion of removal of the second polysilicon layer to selectively etch a remainder of the first polysilicon layer using a high selectivity etch, whereby the gate structure is formed.

Functions of the present invention having the above configuration will be described below.

According to the present invention, a second polysilicon layer is deposited over an oxide layer such that the bottom surface of the second polysilicon layer within a trench is above the bottom surface of the first polysilicon layer, and the top surface of the second polysilicon layer within the trench is below the top surface of the first polysilicon layer. A third polysilicon layer is deposited over the second polysilicon layer subjected to a planarization process. During forming a gate structure, an etch stop is detected at the completion of removal of each of the third polysilicon layer and the second polysilicon layer. A thin layer of the remainder of the first polysilicon layer is carefully removed using a highly selective etch process. Accordingly, unlike the conventional process, the remainder of exposed first polysilicon layer can be removed without excessive removal of a gate insulator layer underlying the first polysilicon layer and the difficulty with end point detection of a gate polysilicon etch is solved, thereby preventing generation of a parasitic edge transistor at a trench corner and a reduction of a gate withstand voltage which are caused in a conventional STI process.

Thus, the invention described herein makes possible the advantages of providing a method for producing a semiconductor device using a shallow trench isolation (STI) process capable of preventing a bird's beak shift and dopant segregation in a well, which are caused in a LOCOS process, while solving the difficulty with end point detection of a gate polysilicon etch which is caused in the STI process, thereby preventing the formation of a parasitic edge transistor at a trench corner and a reduction of a gate withstand voltage.

In order that the present invention be more readily understood, specific embodiments thereof will now be described with reference to the accompanying drawings.

BRIEF DESCRIPTION OF THE DRAWINGS

Fig. 1 is a cross-sectional view of a device structure obtained after the completion of the step of forming poly 1 according to a method of the present invention for producing a semiconductor device using a self-aligned shallow trench isolation process.

Fig. 2 is a cross-sectional view of a device structure obtained after the completion of the step of forming trenches according to the method of the present invention for producing a semiconductor device using a self-aligned shallow trench isolation process.

Fig. 3 is a cross-sectional view of a device structure obtained after the completion of the step of forming an oxide layer according to the method of the present invention for producing a semiconductor device using a self-aligned shallow trench isolation process.

Fig. 4 is a cross-sectional view of a device structure obtained after the completion of the step of forming poly 2 according to the method of the present invention for producing a semiconductor device using a self-aligned shallow trench isolation process.

Fig. 5 is a cross-sectional view of a device structure obtained after the completion of the planarization step according to the method of the present invention for producing a semiconductor device using a self-aligned shallow trench isolation process.

Fig. 6 is a cross-sectional view of a device structure after the completion of the step of forming poly 3 according to the method of the present invention for producing a semiconductor device using a self-aligned shallow trench isolation process.

Fig. 7 is a cross-sectional view of a device structure obtained after the completion of the step of forming a polysilicon gate according to the method of the present invention for producing a semiconductor device using a self-aligned shallow trench isolation process.

Fig. 8 is a cross-sectional view of the device structure shown in Fig. 7 rotated ninety degrees to show the cross-section along the source/channel/drain of a transistor.

Fig. 9 is a cross-sectional view of a device structure illustrating an active region including the source, channel, and drain regions after the completion of the step of removing the remaining poly 1 according to the method of the present invention for producing a semiconductor device using a self-aligned shallow trench isolation process.

Fig. 10 is a cross-sectional view of a device structure obtained after the completion of the step of implanting impurity ions according to the method of the present invention for producing a semiconductor device using a self-aligned shallow trench isolation process.

Fig. 11 is a cross-sectional view of the device structure shown in Fig. 10 rotated ninety degrees to show the cross-section along the source/channel/drain of a transistor.

Fig. 12 is cross section view of a device structure obtained after the completion of the step of forming notches during formation of an alignment structure according to the method of the present invention for producing a semiconductor device using a self-aligned shallow trench isolation process.

Fig. 13 is cross section view of a device structure after the completion of the step of forming alignment keys following the step described in conjunction with Fig. 12.

Fig. 14 is cross section view of a device structure obtained during formation of an alignment structure different from that shown in Fig. 13.

Fig. 15 is a cross-sectional view illustrating a device structure having a bird's beak portion obtained by a conventional LOCOS process.

Fig. 16 is a cross-sectional view illustrating trench corner portions between elements of a device structure obtained by a conventional STI process.

DESCRIPTION OF THE PREFERRED EMBODIMENTS

Hereinafter, embodiments of the present invention will be described with respect to a method for producing a semiconductor device using an element isolation process and with reference to the accompanying drawings.

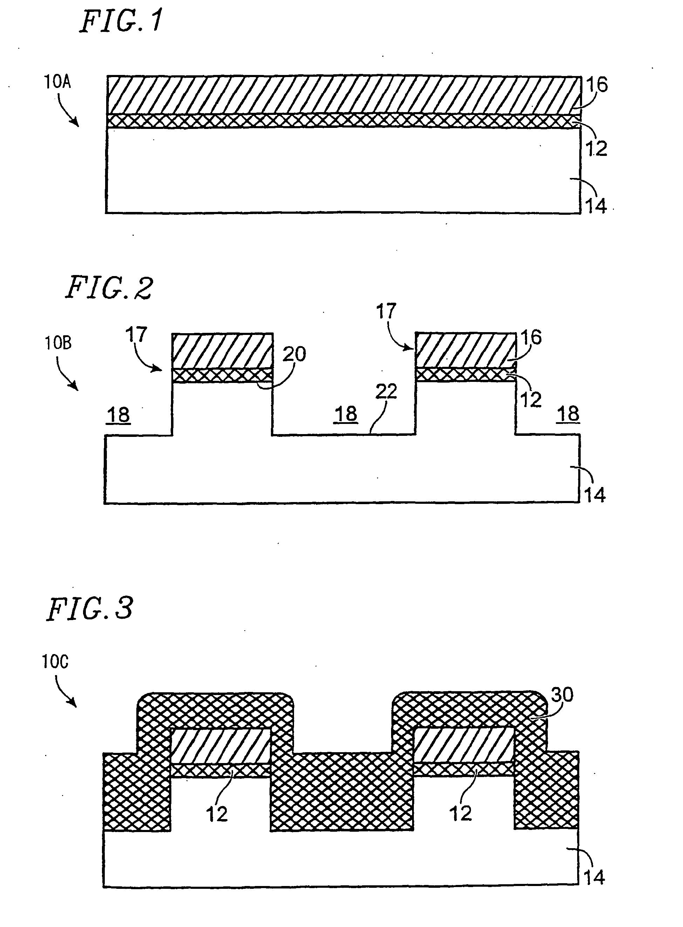

Fig. 1 is a cross-sectional view of a device structure 10A obtained after the completion of the step of forming a first polysilicon layer 16, which may also be referred to as poly 1 throughout this description, according to a method of the present invention for producing a semiconductor device using a self-aligned shallow trench isolation process.

As shown in Fig. 1, for the present method, a semiconductor substrate 14, e.g., a silicon substrate (Si substrate), is provided. An n-well or a p-well may be formed if desired prior to isolating adjacent device areas . Next, a gate insulator 12, which is a gate insulating layer (e.g., a gate oxide film), is grown, or grown and deposited overlying the semiconductor substrate 14. Poly 1 is deposited overlying the gate insulator 12, following formation of n-wells or p-wells, if any. In this manner, the device structure 10A is formed after the process of forming the sacrificial gate (the process of forming poly 1). The thickness of poly 1 is referred to as $T_{p1}$.

In another method useful for understanding the present invention, which is suitable to a sacrificial gate process, a silicon nitride layer replaces, as a sacrificial gate material, the poly 1 overlying the gate insulator 12. Also the gate insulator 12, may comprise silicon oxide (e.g., silicon dioxide), or a high-k material, such as silicon oxynitride, hafnium oxide, zirconium oxide, lanthanum oxide or other suitable gate dielectric material.

Fig. 2 is a cross-sectional view of a device structure 10B obtained after the completion of the step of forming trenches according to the method of the present invention for producing a semiconductor device using a self-aligned shallow trench isolation process.

As shown in Fig. 2, the poly 1, the gate insulator 12, and the semiconductor substrate 14 are partially etched to form trenches 18, thereby forming adjacent device regions 17. In this manner, the device structure 10B is obtained after the process of forming the trenches. The depth of the trenches 18 into the semiconductor substrate 14, which is referred to as $X_{STI}$, extends from the top of the substrate surface 20 to the bottom 22 of the trenches 18 to achieve surface planarity following subsequent polishing. The tolerance (uncertainty or variation) in the trench depth is referred to as $\Delta X_{STI}$. Following the partial etching of the semiconductor substrate 14, a cleaning may be performed to reduce, or eliminate, etch damage.

Fig. 3 is a cross-sectional view of a device structure 10C obtained after the completion of the step of forming an oxide layer according to the method of the present invention for producing a semiconductor device using a self-aligned shallow trench isolation process.

As shown in Fig. 3, an oxide layer 30 is deposited on the poly 1 and on the substrate 14 within the trenches 18, thereby obtaining the device structure 10C after the process of forming the oxide layer. The purpose of depositing the oxide layer 30 is to refill the trenches 18 with the oxide. The oxide layer 30 is formed so as to have a thickness greater than the depth of the trench. Specifically, the oxide layer 30 has a minimum thickness that is greater than the maximum possible depth of the trench 18 into the semiconductor substrate 14. Referring to the thickness of the oxide layer 30 as $T_{ox}$, and the tolerance (uncertainty or variation) in the thickness of the oxide layer 30 as $\Delta T_{ox}$, the oxide layer 30 should be deposited and processed so that the final processed thickness satisfies the following expression (1):

$$T_{ox} - \Delta T_{ox} > X_{STI} + \Delta X_{STI} \quad \ldots \ldots \quad (1).$$

The oxide layer 30 may comprise a thin thermal oxide to provide a good interface between the oxide and silicon in the field followed by a deposited oxide. The deposited oxide can be formed by a variety of film formation methods including chemical vapor deposition (CVD) methods, such as, LTO, HPCVD, PECVD, or other CVD methods. Non-CVD methods such as sputtering may also be used. Following deposition of oxide by any suitable film formation method, the oxide may then be densified at a higher temperature, if necessary or desired.

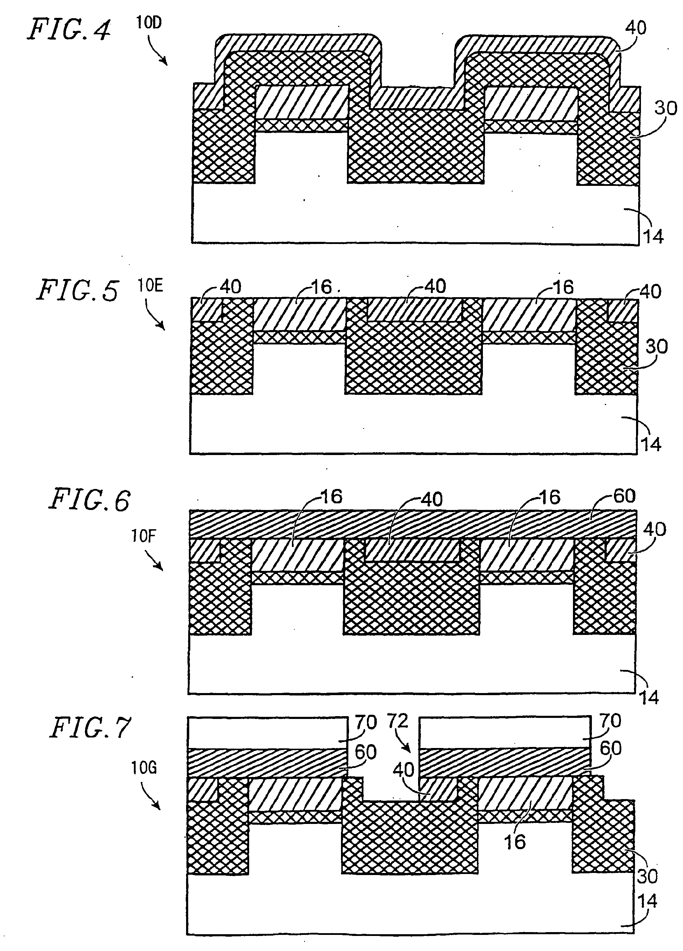

Fig. 4 is a cross-sectional view of a device structure 10D obtained after the completion of the step of forming poly 2 according to the method of the present invention for producing a semiconductor device using a self-aligned shallow trench isolation process.

As shown in Fig. 4, a second polysilicon layer 40, also referred to herein as poly 2, or field poly, is deposited overlying the device structure 10C (or the oxide layer 30). The thickness of poly 2 is referred to as $T_{p2}$, and the thickness of poly 1 (or the total thickness of poly 1 and the gate insulator 12) is referred to as $T_{p1}$. Poly 2 should have a thickness selected such that the maximum thickness of poly 2 plus the maximum thickness of the oxide layer 30 is thinner than the minimum depth of the trench 18 plus the minimum thickness of poly 1. Accordingly, the thickness of poly 2 should satisfy the following expression (2):

$$T_{p2}+\Delta T_{p2}+T_{OX}+\Delta T_{OX}<X_{STI}-\Delta X_{STI}+T_{p1}-\Delta T_{p1} \quad \ldots \ldots \quad (2).$$

To satisfy expression (2) and still have a meaningful thickness of poly2, there is a maximum desired oxide thickness. The maximum desired thickness of the oxide layer 30 should satisfy the following expression (3):

$$T_{OX}+\Delta T_{OX}<X_{STI}-\Delta X_{STI}+T_{p1}-\Delta T_{p1}-T_{p2}-\Delta T_{p2} \quad \ldots \ldots \quad (3).$$

This should result in the top surface of the oxide layer 30 within the trench 18 being above the bottom surface of poly 1, and the top surface of poly 2 within the trench 18 being below the top surface of poly 1. In this manner, the device structure 10D is obtained after the process of forming poly 2.

After poly 2 is deposited overlying the oxide layer 30, a sacrificial oxide layer, not shown, is deposited overlying the device structure 10D. The sacrificial oxide layer may be, for example, undensified TEOS. In one embodiment, the sacrificial oxide layer is one and a half times thicker than the maximum thickness of poly 1. In another embodiment, the sacrificial oxide layer should have a thickness such that the combined thickness of the gate insulator 12, poly 1, the oxide layer 30, poly 2, and the sacrificial oxide layer is approximately two times the total step height of the active area features, which corresponds to the actual physical relief of the top surfaces.

Fig. 5 is a cross-sectional view of a device structure 10E obtained after the completion of the planarization step according to the method of the present invention for producing a semiconductor device using a self-aligned shallow trench isolation process.

As shown in Fig. 5, poly 2 (the second polysilicon layer 40) and the oxide layer 30 are partially polished by a low-selection-ratio CMP and then the resultant device structure is polished and planarized from the top surface thereof using a high-selection-ratio CMP to stop at the top surface of the second polysilicon layer 40 as a stopper in the field region. In this manner, the device structure 10E is obtained after the planarization process. The planarization process may be achieved using the following two-step process. In the first step, a non-selective slurry is used to remove the overlying oxide and the portion of the second polysilicon layer 40 overlying active areas within the device regions. The second step utilizes a selective polish, which continues to remove the oxide layer 30 overlying the active area within the device regions and stops at the first polysilicon layer 16 overlying the active areas within the device regions and at the top surface of the second polysilicon layer 40 in the field regions. The actual field oxide (the oxide layer 30 in the field regions) is not polished in this planarization step. During the selective polish, the active areas of the device are much smaller than the field areas and the polish rate of oxide can be selected to be sufficiently higher than that of polysilicon, for example, greater than 5:1 oxide to polysilicon etch ratio, so this CMP process can be readily achieved. Since the following expression (4),

$$T_{p2}+\Delta T_{p2}+T_{OX}+\Delta T_{OX}<X_{STI}-\Delta X_{STI}+T_{p1}-\Delta T_{p1} \quad \ldots \ldots \quad (4),$$

is satisfied, the oxide layer 30 on poly 1 is completely removed before the CMP stop at the field poly 2. By using the top surface of poly 2 as the CMP stop, global planarization may be achieved without using a reverse mask photoresist and etching process.

At this point, it is possible to continue with processing as described below in detail. In a method useful for understanding the present invention, if a sacrificial gate process were used any sacrificial gate material, would be removed. The sacrificial gate material could be polysilicon, silicon nitride or other suitable sacrificial gate material. The underlying gate insulator may also be removed if desired. A replacement gate insulator, for example a high-k gate insulator, maybe formed. A replacement gate process could then be completed.

Fig. 6 is a cross-sectional view of a device structure 10F after the completion of the step of forming poly 3 according to the method of the present invention for producing a semiconductor device using a self-aligned shallow trench isolation process.

As shown in Fig. 6, a third polysilicon layer 60, also referred to herein as poly 3, is deposited overlying the device structure 10E planarized by CMP. The actual gate polysilicon thickness will correspond to the sum of the poly 3 thickness plus the thickness of poly 1 (the first polysilicon layer 16) that remains after CMP. In this manner, the device structure 10F is obtained after the process of forming poly 3.

Fig. 7 is a cross-sectional view of a device structure 10G obtained after the completion of the step of forming a polysilicon gate according to the method of the present invention for producing a semiconductor device using a self-aligned shallow trench isolation process.

As shown in Fig. 7, photoresist 70 is applied to poly 3 (the third polysilicon layer 60) and patterned to define a polysilicon gate structure 72. A two-step plasma etch process may be used to etch the poly 3/poly 1 (the first polysilicon layer 16) stack and the poly 3/poly 2 (the second polysilicon layer 40) stack. The first step has a high polysilicon etch rate and stops at the end point, which corresponds to the point at which exposed poly 2 has been completely removed. Notice that some poly 2 remains under poly 3 and the photoresist. In this manner, the device structure 10G is obtained after the process of forming the polysilicon gate.

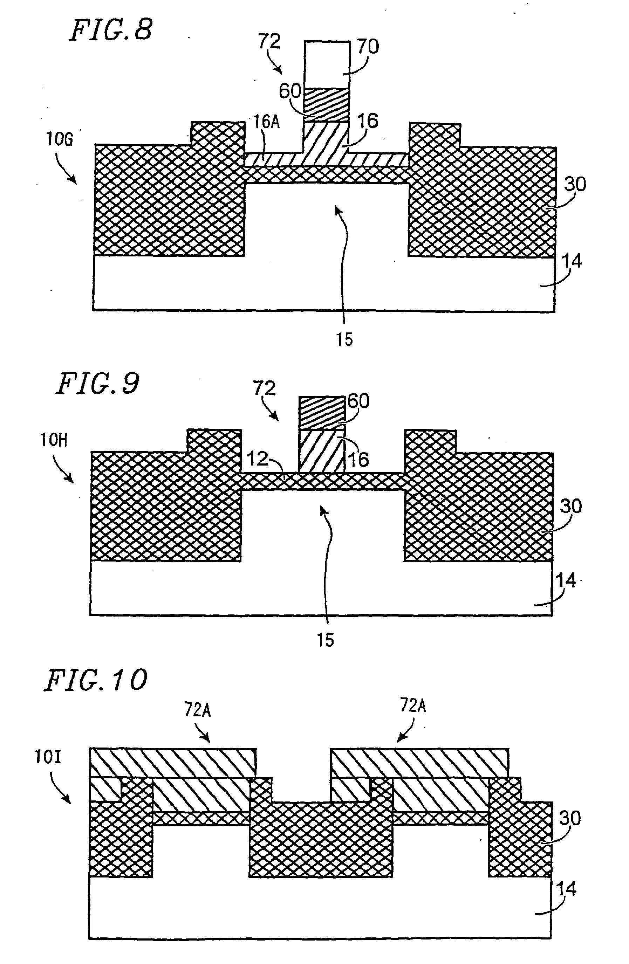

Fig. 8 is a cross-sectional view of the device structure 10G shown in Fig. 7 rotated ninety degrees to show the cross-section along the source/channel/drain (a transistor region 15) of a transistor.

Since $T_{ox}-\Delta T_{ox}>X_{STI}+\Delta X_{STI}$, poly 1 (the first polysilicon layer 16) is not completely removed from the active region (the transistor region 15), as shown in Fig. 8. The thickness of the remaining poly 1 should be independent of the CMP process.

After poly 2 (the second polysilicon layer 40) has been removed, a highly selective etch is used to etch the remaining portion of poly 1 (the first polysilicon layer 16) that is not covered by photoresist. The highly selective etch stops at the bottom surface of poly 2 and leaves a thin layer 16A of poly 1 (the first polysilicon layer 16) over the gate insulator 12.

Fig. 9 is a cross-sectional view of a device structure 10H illustrating the active region (the transistor region 15) including the source, channel, and drain regions after the completion of the step of removing the remaining poly 1 according to the method of the present invention for producing a semiconductor device using a self-aligned shallow trench isolation process.

As showing Fig. 9, a highly selective etch is performed to remove the remaining thin layer 16A of poly 1, whereby micro-trenching may be reduced, or eliminated. By using high selectivity plasma etching, the remainder of poly 1 (the first polysilicon layer 16) can be selectively and securely removed without excessive removal of gate insulator 12 in the source and drain regions.

The photoresist 70 is then stripped leaving the polysilicon gate stack that comprises the remaining portions of poly 1 and poly 3 over each active area. Some poly 2 (i.e., the portion of the second polysilicon layer 40 shown in Fig. 7) remains under the portion of poly 3 (the third polysilicon layer 60) extending beyond the active region (the transistor region 15), which is not visible in Fig. 9. In this manner, the device structure 10H is obtained after the process of removing the remaining poly 1.

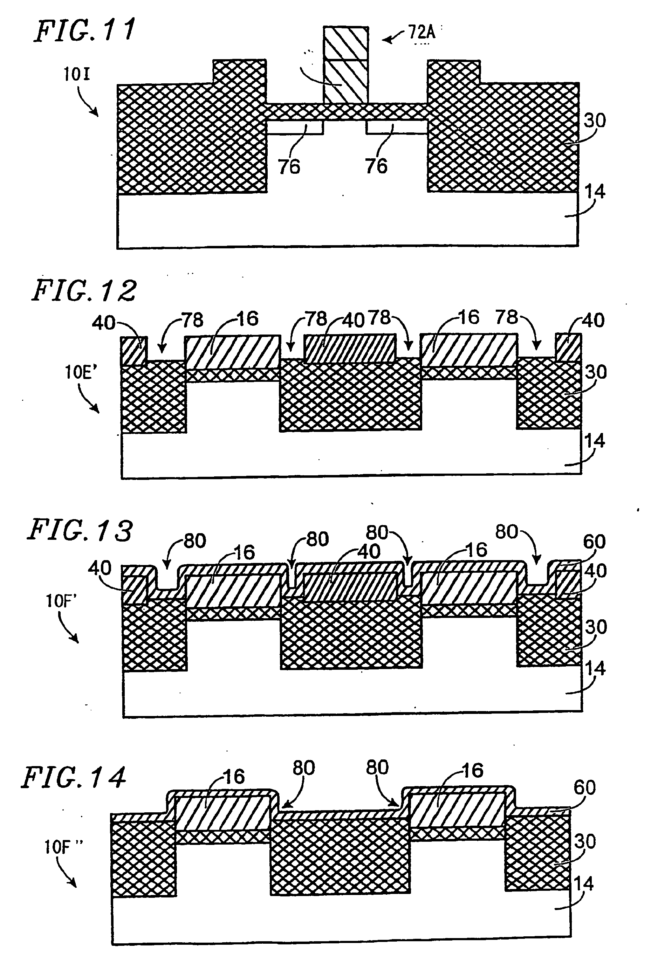

Fig. 10 is a cross-sectional view of a device structure 10I obtained after the completion of the step of implanting impurity ions according to the method of the present invention for producing a semiconductor device using a self-aligned shallow trench isolation process. Fig. 11 is a cross-sectional view of the device structure 10I shown in Fig. 10 rotated ninety degrees to show the cross-section along the source/channel/drain (the transistor region 15) of a transistor.

After formation of the polysilicon gate structure 72, impurity ions are implanted into the semiconductor substrate 14 to form source and drain regions 76 that are self-aligned to the gate structure 72, as shown in Figs. 10 and 11. Poly 1, poly 2, and poly 3 are also converted to n+ or p+ polysilicon as is common in conventional processes. The polysilicon gate structure 72 may alternatively be doped prior to the gate electrode etch, and prior to (or during) implanting of impurity ions into portions of the semiconductor substrate 14 which correspond to the source and drain regions 76. The polysilicon gate may also be salicided. Several methods of polysilicon gate doping, silicide or self aligned processes, including salicide processes, may be applied to the present process. A polysilicon gate structure 72A following doping is shown in Fig. 10 and Fig. 11. In this manner, the device structure 10I is obtained after the process of implanting impurity ions.

Each embodiments of the present invention may exhibit some, or all, of the advantages of modified STI processes, such as negligible narrow channel effects, high gate insulator integrity, uniform threshold voltage across the transistor, and low field leakage current.

In an additional embodiment, an alignment key is incorporated into the modified STI process described above without the need for an additional photoresist and masking step. Fig. 12 illustrates a cross-sectional view of the device structure after an additional etch step is performed after the process leading up to the planarized structure shown in Fig. 5 above. As shown in Fig. 12, after the CMP step discussed above, an oxide etch is used to remove the exposed portion of the oxide layer 30. A plasma etch or a wet etch solution containing HF may be used to etch the oxide layer 30. In the example embodiment shown, the exposed portion of the oxide layer 30 is etched to remove approximately 100 nanometers of oxide forming recesses, i.e., notches 78 shown in Fig. 12. In this manner, a device structure 10E'is obtained after the process of etching the oxide is performed after the planarizing process described in conjunction with Fig. 5.

Following etching of the oxide layer 30, the polysilicon layer 60 may be deposited over the device structure 10E', as shown in Fig. 13. The polysilicon layer 60 shown in Fig. 13 corresponds to poly 3 shown in Fig. 6, but with the addition of the alignment keys 80 to the portions corresponding to the notches 78. The process can then be completed as described above to form a final gate structure. The alignment keys 80 are now available for subsequent lithography alignment needs. In this manner, a device structure 10F' having an alignment structure is obtained after the process of forming poly 3 over the device structure 10E' shown in Fig. 12.

In comparative example, alignment keys can be incorporated into a single poly STI structure using a modified STI process without poly 2. The resulting alignment structure with edges that serve as alignment keys 80 is shown in Fig. 14. The alignment keys 80 were formed by etching the oxide following CMP. After etching, another polysilicon layer corresponding to poly 3 is deposited. But in this case, there was no poly 2 used in the process. Subsequent processing may be used to complete the device structure to form a transistor with a gate, and source and drain regions. In this manner, a device structure 10F'' is obtained in the case where an alignment structure different from that shown in Fig. 13 is formed.

Although exemplary embodiments, including possible variations have been described, the scope of the present invention shall not be limited to these examples, but rather is to be determined by the following claims.

As described above, an STI process of the present invention includes: a poly 1 formation step of forming the first polysilicon layer 16 overlying the semiconductor substrate 14; a trench formation step of forming the trench 18 (an element isolation trench) through the first polysilicon layer 16, and into the semiconductor substrate 14; an oxide layer formation step of filling the trench 18 with an oxide layer 30 such that the top surface of the oxide layer 30 within the trench 18 is higher than the bottom surface of the first polysilicon layer 16; a poly 2 formation step of depositing the second polysilicon layer 40 overlying the oxide layer 30 such that the top surface of the second polysilicon layer 40 within the trench 18 is lower than the top surface of the first polysilicon layer 16; a planarizing step of planarizing the second polysilicon layer 40, the oxide layer 30, and the first polysilicon layer 16 using a CMP process; an alignment key formation step of forming alignment keys by selectively etching the oxide layer 30; a poly 3 formation step of depositing the third polysilicon layer 60 over the planarized device structure; and a gate structure formation step of patterning the second polysilicon layer 40, the third polysilicon layer 60, and the first polysilicon layer 16 using a photoresist, while detecting an etch stop at the completion of the removal of the second polysilicon layer 40 and carefully removing a thin layer of the remaining first polysilicon layer 16 using a selective etch process, whereby a gate structure is formed. Accordingly, the second polysilicon layer 40 is deposited over the oxide layer 30 such that the bottom surface of the second polysilicon layer 40 within the trench 18 is above the bottom surface of the first polysilicon layer 16, and the top surface of the second polysilicon layer 40 within the trench 18 is below the top surface of the first polysilicon layer 16. The third polysilicon layer 60 is deposited over the second polysilicon layer 40 subjected to a planarization process. During forming the gate structure, an etch stop is detected at the completion of removal of each of the third polysilicon layer 60 and the second polysilicon layer 40. A thin layer of the remainder of the first polysilicon layer 16 is carefully removed using a highly selective etch process. Accordingly, unlike the conventional process, the remainder of exposed first polysilicon layer 16 can be removed without excessive removal of the gate insulator layer 12 underlying the first polysilicon layer 16. Further, a bird's beak shift and dopant segregation in a well, which are caused in a LOCOS process, while solving the difficulty with end point detection of a gate polysilicon etch which is caused in the STI process, thereby preventing the formation of a parasitic edge transistor at a trench corner and a reduction of a gate withstand voltage.

As described above, according to the present invention, a second polysilicon layer is deposited over an oxide layer such that the bottom surface of the second polysilicon layer within a trench is above the bottom surface of the first polysilicon layer, and the top surface of the second polysilicon layer within the trench is below the top surface of the first polysilicon layer. A third polysilicon layer is deposited over the second polysilicon layer subjected to a planarization process. During forming a gate structure, an etch stop is detected at the completion of removal of each of the third polysilicon layer and the second polysilicon layer. A thin layer of the remainder of the first polysilicon layer is carefully removed using a highly selective etch process. Accordingly, unlike the conventional process, the remainder of exposed first polysilicon layer can be removed without excessive removal of a gate insulator layer underlying the first polysilicon layer and the difficulty with end point detection of a gate polysilicon etch, which is caused in a conventional STI process, is solved, thereby preventing generation of a parasitic edge transistor at a trench corner and a reduction of a gate withstand voltage.

### Claims

1. A method for producing a semiconductor device using a self-aligned shallow trench isolation process which isolates elements formed so as to be self-aligned to a gate structure, the method comprising the steps of:

   providing a first polysilicon layer (16) overlying a gate insulator layer (12) on a substrate (14);
   forming a trench (18) through the first polysilicon layer (16), and into the substrate (14);
   providing an oxide layer (30) overlying the substrate including the trench (18) such that a top surface of the oxide layer (30) within the trench is higher than a bottom surface of the first polysilicon layer (16);
   providing a second polysilicon layer (40) overlying the oxide layer (30) such that a top surface of the second polysilicon layer (40) within the trench (18) is lower than the top surface of the first polysilicon layer (16); and planarizing the second polysilicon layer (40), the oxide layer (30), and the first polysilicon layer (16), while stopping the step of planarizing at the top surface of the second polysilicon layer (40) within the trench (18), and selectively etching the second polysilicon layer (40) and the first polysilicon layer (16) to pattern the gate structure using a mask, while detecting an etch stop at the completion of removal of the second polysilicon layer (40) and then selectively etching a remainder of the first polysilicon layer (16) using an etch with high selectivity to the underlying gate insulator layer (12), whereby the gate structure is formed.

2. The method for producing a semiconductor device of claim 1, wherein the oxide layer (30) is formed by growing a thin thermal oxide and then depositing the remainder of the oxide using a CVD process, or sputtering.

3. The method for producing a semiconductor device of claim 1, wherein the gate insulator layer (12) is silicon dioxide.

4. The method for producing a semiconductor device of claim 1, wherein the gate insulator layer (12) comprises at least one of silicon oxide, silicon oxynitride, hafnium oxide, zirconium oxide and lanthanum oxide.

5. The method for producing a semiconductor device of claim 1, further comprising the steps of:

   providing a third polysilicon layer (60) on the substrate (14) after planarizing; and
   selectively etching the third polysilicon layer (60), the second polysilicon layer (40), and the first polysilicon layer (16) using patterned photoresist during formation of a gate structure (72), while detecting an etch stop at the completion of removal of the second polysilicon layer (40), whereby a thin layer of first polysilicon layer (16) remains.

6. The method for producing a semiconductor device of claim 1, further comprising the step of etching the oxide layer (30) using an oxide selective etch after the step of planarizing, whereby an alignment key is formed in the oxide layer.

7. The method for producing a semiconductor device of claim 1, further comprising the step of:

   selectively etching the oxide following the step of planarizing the second polysilicon layer, whereby an alignment key is formed in the oxide.

8. The method for producing a semiconductor device of claim 7 wherein the oxide within the trench (18) is etched to remove approximately 100 nanometers of oxide.

9. The method for producing a semiconductor device of claim 1, further comprising the steps of:

   prior to performing the planarizing step, providing a sacrificial oxide layer over the second polysilicon layer, wherein the planarization step includes planarizing the sacrificial oxide layer;
   selectively etching the oxide layer (30) using an oxide selective etch, whereby an alignment key is formed in the oxide layer (30);
   providing a third polysilicon layer (60) overlying the substrate;
   providing photoresist over the third polysilicon layer (60) and patterning the photoresist to define a gate structure (72); and
   selectively etching the third polysilicon layer (60), the second polysilicon layer (40), and the first polysilicon layer (16) using the photoresist, while detecting an etch stop at the completion of removal of the second polysilicon layer to selectively etch a remainder of the first polysilicon layer (16) using a high selectivity etch, whereby the gate structure is formed.

**Patentansprüche**

1. Verfahren zum Herstellen einer Halbleitervorrichtung unter Verwendung eines selbst-justierten Flachgrabenisolationsprozesses, der ausgebildete Elemente selbst-justiert zu einer Gatestruktur isoliert, wobei das Verfahren die Schritte aufweist:

   Bereitstellen einer ersten Polysiliziumschicht (16), die auf einer Gateisolatorschicht (12) auf einem Substrat (14) aufliegt;

Ausbilden eines Grabens (18) durch die erste Polysiliziumschicht (16) und in das Substrat (14) hinein;

Bereitstellen einer Oxidschicht (30), die auf dem Substrat einschließlich des Grabens (18) derart aufliegt, dass eine Oberseite der Oxidschicht (30) innerhalb des Grabens höher ausgerichtet ist als eine Unterseite der ersten Polysiliziumschicht (16);

Bereitstellen einer zweiten Polysiliziumschicht (40), die auf der Oxidschicht (30) derart aufliegt, dass eine Oberseite der zweiten Polysiliziumschicht (40) innerhalb des Grabens (18) tiefer liegt als die Oberseite der ersten Polysiliziumschicht (16); und

Planarisieren der zweiten Polysiliziumschicht (40), der Oxidschicht (30), und der ersten Polysiliziumschicht (16), wobei der Schritt des Planarisierens an der Oberseite der zweiten Polysiliziumschicht (40) innerhalb des Grabens (18) beendet wird, und

selektives Ätzen der zweiten Polysiliziumschicht (40) und der ersten Polysiliziumschicht (16) zum Strukturieren der Gatestruktur mit Hilfe einer Maske, wobei ein Ätzstopp beim Beenden des Entfernens der zweiten Polysiliziumschicht (40) detektiert wird und dann ein Rückstand der ersten Polysiliziumschicht (16) mit Hilfe einer Ätzung hoher Selektivität zur darunter liegenden Gateisolationsschicht (12) selektiv geätzt wird, womit die Gatestruktur ausgebildet wird.

2. Verfahren zum Herstellen einer Halbleitervorrichtung nach Anspruch 1, wobei die Oxidschicht (30) durch Aufwachsen eines dünnen thermischen Oxids und Abscheiden des Restes des Oxids mit Hilfe eines CVD-Prozesses oder Sputtern ausgebildet wird.

3. Verfahren zum Herstellen einer Halbleitervorrichtung nach Anspruch 1, wobei die Gateisolatorschicht (12) aus Siliziumdioxid besteht.

4. Verfahren zum Herstellen einer Halbleitervorrichtung nach Anspruch 1, wobei die Gateisolatorschicht (12) wenigstens eines der Materialien Silziumoxid, Siliziumoxynitrid, Hafniumoxid, Zirkoniumoxid und Lanthanoxid aufweist.

5. Verfahren zum Herstellen einer Halbleitervorrichtung nach Anspruch 1, zusätzlich umfassend die Schritte:

Bereitstellen einer dritten Polysiliziumschicht (60) auf dem Substrat (14) nach der Planarisierung; und

selektives Ätzen der dritten Polysiliziumschicht (60), der zweiten Polysiliziumschicht (40), und der ersten Polysiliziumschicht (16) mit Hilfe des strukturierten Fotolacks während dem Herstellen einer Gatestruktur (72), wobei ein Ätzstopp beim Beenden des Entfernens der zweiten Polysiliziumschicht (40) detektiert wird, wodurch eine dünne Schicht der ersten Polysiliziumschicht (16) verbleibt.

6. Verfahren zum Herstellen einer Halbleitervorrichtung nach Anspruch 1, zusätzlich umfassend den Schritt des Ätzens der Oxidschicht (30) mit Hilfe einer selektiven Oxidätzung nach dem Schritt des Planarisierens, wodurch ein Ausrichtungsschlüssel im Oxid ausgebildet wird.

7. Verfahren zum Herstellen einer Halbleitervorrichtung nach Anspruch 1, zusätzlich umfassend den Schritt:

selektives Ätzen des Oxids, gefolgt von dem Schritt des Planarisierens der zweiten Polysiliziumschicht, wodurch ein Ausrichtungsschlüssel im Oxid ausgebildet wird.

8. Verfahren zum Herstellen einer Halbleitervorrichtung nach Anspruch 7, wobei das Oxid innerhalb des Grabens (18) zum Entfernen von näherungsweise 100 nm Oxid geätzt wird.

9. Verfahren zum Herstellen einer Halbleitervorrichtung nach Anspruch 1, zusätzlich umfassend die Schritte:

vor dem Durchführen des Planarisierungsschrittes, Bereitstellen einer Opfer-Oxidschicht über der zweiten Polysiliziumschicht, wobei der Planarisierungsschritt ein Planarisieren der Opfer-Oxidschicht umfasst;

selektives Ätzen der Oxidschicht (30) mit Hilfe einer selektiven Oxidätzung, wodurch ein Ausrichtungsschlüssel in der Oxidschicht (30) ausgebildet wird;

Bereitstellen einer über dem Substrat aufliegenden dritten Siliziumschicht (60);

Bereitstellen eines Fotolacks über der dritten Polysiliziumschicht (60) und Strukturieren des Fotolacks zur Definition einer Gatestruktur (72); und

selektives Ätzen der dritten Polysiliziumschicht (60), der zweiten Polysiliziumschicht (40), und der ersten Polysiliziumschicht (16) mit Hilfe des Fotolacks, wobei ein Ätzstopp beim Beenden des Entfernens der zweiten Polysiliziumschicht detektiert wird, um einen Rückstand der ersten Polysiliziumschicht (16) mit Hilfe einer Ätzung hoher Selektivität selektiv zu ätzen, wodurch die Gatestruktur ausgebildet wird.

**Revendications**

1. Procédé de production d'un dispositif à semiconducteur en utilisant un processus d'isolation de tranchée peu profonde auto-alignée qui isole des éléments formés afin d'être auto-alignés sur une structure de grille, le procédé comprenant les étapes consistant à :

    former une première couche de polysilicium (16) sur une couche d'isolant de grille (12) sur un substrat (14) ;
    former une tranchée (18) à travers la première couche de polysilicium (16) et dans le substrat (14) ;
    former une couche d'oxyde (30) sur le substrat incluant la tranchée (18) de sorte qu'une surface supérieure de la couche d'oxyde (30) à l'intérieur de la tranchée soit plus élevée qu'une surface de fond de la première couche de polysilicium (16) ;
    former une deuxième couche de polysilicium (40) sur la couche d'oxyde (30) de sorte qu'une surface supérieure de la deuxième couche de polysilicium (40) à l'intérieur de la tranchée (18) soit plus basse que la surface supérieure de la première couche de polysilicium (16) ; et
    aplanir la deuxième couche de polysilicium (40), la couche d'oxyde (30), et la première couche de polysilicium (16), en arrêtant l'étape d'aplanissement au niveau de la surface supérieure de la deuxième couche de polysilicium (40) à l'intérieur de la tranchée (18), et
    attaquer de manière sélective la deuxième couche de polysilicium (40) et la première couche de polysilicium (16) pour configurer la structure de grille en utilisant un masque, en détectant un arrêt d'attaque au moment de l'achèvement de l'enlèvement de la deuxième couche de polysilicium (40) et attaquer ensuite de manière sélective un reste de la première couche de polysilicium (16) en utilisant une attaque avec une sélectivité élevée jusqu'à la couche d'isolant de grille sous-jacente (12), la structure de grille étant ainsi formée.

2. Procédé de production d'un dispositif à semiconducteur selon la revendication 1, dans lequel la couche d'oxyde (30) est formée en faisant croître un oxyde thermique mince et en déposant ensuite le reste de l'oxyde en utilisant un procédé CVD ou une pulvérisation cathodique.

3. Procédé de production d'un dispositif à semiconducteur selon la revendication 1, dans lequel la couche d'isolant de grille (12) est en dioxyde de silicium.

4. Procédé de production d'un dispositif à semiconducteur selon la revendication 1, dans lequel la couche d'isolant de grille (12) comprend au moins l'un parmi l'oxyde de silicium, l'oxynitrure de silicium, l'oxyde de hafnium, l'oxyde de zirconium et l'oxyde de lanthane.

5. Procédé de production d'un dispositif à semiconducteur selon la revendication 1, comprenant en outre les étapes consistant à :

    former une troisième couche de polysilicium (60) sur le substrat (14) après l'aplanissement ; et
    attaquer de manière sélective la troisième couche de polysilicium (60), la deuxième couche de polysilicium (40) et la première couche de polysilicium (16) en utilisant un photorésist configuré, pendant la formation d'une structure de grille (72), en détectant un arrêt d'attaque au moment de l'achèvement de l'enlèvement de la deuxième couche de polysilicium (40), de sorte qu'une couche mince de première couche de polysilicium (16) subsiste.

6. Procédé de production d'un dispositif à semiconducteur selon la revendication 1, comprenant en outre l'étape consistant à attaquer la couche d'oxyde (30) en utilisant une attaque d'oxyde sélective après l'étape d'aplanissement, de sorte que des motifs d'alignement sont formés dans la couche d'oxyde.

7. Procédé de production d'un dispositif à semiconducteur selon la revendication 1, comprenant en outre l'étape consistant à :

    attaquer de manière sélective l'oxyde après l'étape d'aplanissement de la deuxième couche de polysilicium, de sorte que des motifs d'alignement sont formés dans l'oxyde.

8. Procédé de production d'un dispositif à semiconducteur selon la revendication 7, dans lequel l'oxyde à l'intérieur de la tranchée (18) est attaqué pour enlever environ 100 nanomètres d'oxyde.

9. Procédé de production d'un dispositif à semiconducteur selon la revendication 1, comprenant en outre les étapes consistant à :

avant d'effectuer l'étape d'aplanissement, former une couche d'oxyde destinée à être sacrifiée, sur la deuxième couche de polysilicium, l'étape d'aplanissement comprenant l'aplanissement de la couche d'oxyde destinée à être sacrifiée ;

attaquer de manière sélective la couche d'oxyde (30) en utilisant une attaque d'oxyde sélective, de sorte que des motifs d'alignement sont formés dans la couche d'oxyde (30) ;

former une troisième couche de polysilicium (60) sur le substrat ;

former un photorésist sur la troisième couche de polysilicium (60) et configurer le photorésist pour définir une structure de grille (72) ; et

attaquer de manière sélective la troisième couche de polysilicium (60), la deuxième couche de polysilicium (40) et la première couche de polysilicium (16) en utilisant le photorésist, en détectant un arrêt d'attaque au moment de l'achèvement de l'enlèvement de la deuxième couche de polysilicium pour attaquer de manière sélective un reste de la première couche de polysilicium (16) en utilisant une attaque avec une sélectivité élevée, de sorte que la structure de grille est formée.

FIG.1

10A

16

12

14

FIG.2

10B

17

20

17

16

12

18        18    22    18

14

FIG.3

10C

30

12    12

14

*FIG.4*  10D

40

30

14

*FIG.5*  10E

40    16    40    16    40

30

14

*FIG.6*

16    40    16    60

10F

40

14

*FIG.7*

70    72    70

60

10G

40

60

16

30

14

*FIG.8*

10G

72  70
60  16
16A

30

14

15

*FIG.9*

10H

72
60
12  16

30

14

15

*FIG.10*

72A  72A

10I

30

14

*FIG.11*

10I

72A

76     76

30

14

*FIG.12*

40    78    16    78   40 78    16   78    40

10E'

30

14

*FIG.13*

80    16    80    80    16    80    60

40                40                40

10F'                              30

14

*FIG.14*

16    80    80    16    60

10F"                        30

14

## FIG. 15

Oxide mask layer

100

Bird's beak
(linewidth shift)

Si

B B B

Dopant segregation and
reduction of withstand
field voltage

## FIG. 16

GP Poly

203

Formation of parasitic
transistor

Reduction of
withstand voltage
due to thinning
of gate film

Si

200

201, 202

**EP 1 353 369 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5362668 A
- US 5948698 A